# EUROPEAN PATENT APPLICATION

(11) **EP 4 772 679 A1**
(43) Date of publication of application: **08.07.2026**
(21) Application number: 24859923.5
(22) Date of filing: 29.08.2024
(51) Int. Cl.: C30B 29/04, B23K 26/53, C01B 32/28, C30B 33/04, H01L 21/304

(54) **DIAMOND PROCESSING METHOD**

(30) Priority: 30.08.2023 JP 2023140527
(71) Applicant: Shin-Etsu Polymer Co., Ltd., Tokyo 100-0004 (JP); SHIN-ETSU CHEMICAL CO., LTD., Tokyo 100-0005 (JP); National University Corporation Saitama University, Saitama City, Saitama 338-8570 (JP)
(72) Inventor: IKENO, Junichi, Saitama-shi, Saitama 338-8570 (JP); YAMADA, Yohei, Saitama-shi, Saitama 338-8570 (JP); SUZUKI, Hideki, Saitama-shi, Saitama 331-0811 (JP); MATSUO, Rika, Saitama-shi, Saitama 331-0811 (JP); NOGUCHI, Hitoshi, Annaka-shi, Gunma 379-0195 (JP)
(74) Representative: SSM Sandmair
(86) International application number: PCT/JP2024/031033
(87) International publication number: WO 2025/047896

(57) **Abstract**

In a method of processing a diamond substrate, a laser condenser 190 is arranged to face a main surface 10a of a {001} plane of a substrate 10; a first starting point 221 and a second starting point 222 formed of processing marks 21 are formed by emitting laser light B to irradiate positions each set on a first crystal face 111 and a second crystal face 112 that form a wedge structure with a tip that becomes thinner toward the main surface 10a inside the substrate 10, among crystal faces constituting a {111} plane; starting points are formed on the processing marks 21 formed by irradiating the first starting point 221 and the second starting point 222 with the laser light B in a superimposed manner; and processing marks are formed by irradiating positions between the first starting point 221 and the second starting point 222 with laser light so that cleavages generated from the first starting point 221 and the second starting point 222 obtained by irradiation with the laser light B in a superimposed manner each extend along the first crystal face 111 and the second crystal face 112 and are connected at a tip of the wedge structure.

## Description

### TECHNICAL FIELD

The present invention relates to a method of processing diamond, more specifically, to a method of processing diamond by processing single crystal diamond using laser light.

### BACKGROUND ART

Conventionally, silicon carbide (SiC) and gallium nitride (GaN) have been provided as semiconductor materials suitable for power devices instead of silicon (Si). Compared with these conventional semiconductor materials, a diamond semiconductor is attracting attention as a next-generation semiconductor material due to higher breakdown electric field and power control index as well as the highest thermal conductivity, and research and development for practical application are in progress. Nitrogen-vacancy centers (NV centers) in diamond, enabling highly sensitive magnetic detection at room temperature, have been researched and are expected to be applied to magnetic sensors (see Patent Literature 1).

Single crystal diamond, which is expected to be applied to semiconductors, is synthesized by a high-temperature high-pressure method (HPHT method) or homoepitaxial growth, but these synthesis methods have difficulty in enlarging the area of a bulk substrate of single crystal diamond for use in semiconductor processes. Therefore, a vapor phase synthesis method (CVD method) that enables heteroepitaxial growth of single crystal diamond using single crystal magnesium oxide (MgO) as a base crystal, has been applied due to its superiority in enlarging the area.

A diamond substrate is manufactured by slicing a diamond single crystal ingot, or a block obtained by cutting the ingot to a predetermined length, to a fixed thickness with a wire saw using diamond as abrasive particles. The wire of the wire saw has a diameter of, for example, at least several tens of micrometers. Therefore, a predetermined width portion along a cut surface is lost as a processing allowance when a diamond single crystal ingot or a block is sliced into diamond substrates.

Further, a method of manufacturing a diamond substrate from a diamond ingot using laser light has been disclosed (see Patent Literature 2). In this method, a modified layer having a modified crystal structure is formed by condensing laser light and irradiating the diamond ingot with the laser light to a predetermined depth from a main surface of the diamond ingot, and scanning the diamond ingot in two dimensions. A diamond substrate is stripped off from the modified layer.

### CITATION LIST

### PATENT LITERATURE

Patent Literature 1: Japanese Unexamined Patent Application Publication No. 2015-59069
Patent Literature 2: Japanese Unexamined Patent Application Publication No. 2020-50563

### SUMMARY OF THE INVENTION

### TECHNICAL PROBLEM

A diamond single crystal has a property that cleavage easily progresses along a {111} plane. When a diamond ingot or a block having a {001} plane as a main surface is two-dimensionally scanned with laser light, a modified layer develops on a {111} plane, which is a cleavage plane, and cleavage easily occurs not on the {001} plane but on the {111} plane. Therefore, it is not easy to create a desired diamond substrate having a {001} plane as a main surface.

This invention has been proposed in view of the above-described circumstances, and an object is to provide a method of processing diamond that can manufacture a diamond substrate having a {001} plane as a main surface from a single crystal diamond having a {001} plane as a main surface.

### SOLUTION TO PROBLEM

To solve the aforementioned problems, a method of processing a substrate of the present invention includes: a step of arranging a laser condenser configured to condense laser light, to face a main surface of a {001} plane of a single crystal diamond substrate; a step of forming a first starting point and a second starting point formed of processing marks by condensing the laser light using the laser condenser and irradiating, with the laser light, positions each set on a first crystal face and a second crystal face that form a wedge structure with a tip that becomes thinner toward the main surface inside the substrate, among crystal faces constituting a {111} plane; a step of forming starting points on the processing marks formed, by condensing the laser light using the laser condenser and irradiating the first starting point and the second starting point in a superimposed manner; and a step of forming processing marks by condensing the laser light using the laser condenser and irradiating positions between the first starting point and the second starting point with the laser light so that cleavages each extend along the first crystal face and the second crystal face from the starting point and are connected at the tip of the wedge structure.

In the step of forming processing marks, a modified layer including processing marks obtained by pyrolyzing diamond into graphite and cleavage formed around the processing marks along the {111} plane may be formed. The first starting point and the second starting point may be set at the same depth from the main surface of the substrate. In the step of forming processing marks by irradiating positions between the first starting point and the second starting point with the laser light, the laser light may be condensed to the same depth as the depth of the first starting point and the second starting point to form processing marks.

In the step of forming processing marks by irradiating positions between the first starting point and the second starting point with the laser light, processing marks may be each formed so as to converge at the tip of the wedge structure along the first crystal face and the second crystal face from the first starting point and the second starting point toward the second starting point and the first starting point that are faced.

The step of forming processing marks by irradiating positions between the first starting point and the second starting point with the laser light may include a step of forming processing marks from one of the first starting point and the second starting point toward the other of the first starting point and the second starting point along the first crystal face or the second crystal face to the tip of the wedge structure, and a step of forming processing marks from the other of the first starting point and the second starting point toward one of the first starting point and the second starting point along the first crystal face or the second crystal face to the tip of the wedge structure.

In the step of forming processing marks by irradiating positions between the first starting point and the second starting point with the laser light, a modified layer including processing marks obtained by pyrolyzing diamond into graphite and cleavage around the processing marks along the {111} plane may be formed.

The step of forming processing marks by irradiating positions between the first starting point and the second starting point with the laser light may include a step of forming processing marks to form cleavage from the first starting point along the first crystal face to the tip of the wedge structure, and a step of forming processing marks to form cleavage from the second starting point along the second crystal face to the tip of the wedge structure.

### ADVANTAGEOUS EFFECTS OF INVENTION

According to the present invention, it is possible to manufacture a diamond substrate having a {001} plane as a main surface from a single crystal diamond having a {001} plane as a main surface.

### BRIEF DESCRIPTION OF DRAWINGS

[FIG. 1] FIG. 1 is a perspective view illustrating a schematic configuration of a processing device.
[FIG. 2] FIG. 2 is a plan view of a substrate to be processed by a processing device.
[FIG. 3] FIG. 3 is a schematic diagram illustrating arrangement of a {111} plane in a substrate.
[FIG. 4] FIG. 4 is a cross-sectional view illustrating a processing method of the present embodiment.
[FIG. 5A] FIG. 5A is a diagram illustrating a principle of the processing method of the present embodiment.
[FIG. 5B] FIG. 5B is a diagram illustrating a principle of the processing method of the present embodiment.
[FIG. 6A] FIG. 6A is a diagram illustrating a processing method of the present embodiment.
[FIG. 6B] FIG. 6B is a diagram illustrating a processing method of the present embodiment.
[FIG. 7A] FIG. 7A is a diagram illustrating a processing method of the present embodiment.
[FIG. 7B] FIG. 7B is a diagram illustrating a processing method of the present embodiment.
[FIG. 8A] FIG. 8A is a diagram illustrating a processing method of the present embodiment.
[FIG. 8B] FIG. 8B is a diagram illustrating a processing method of the present embodiment.
[FIG. 9A] FIG. 9A is a photomicrograph showing Experimental example 1.
[FIG. 9B] FIG. 9B is a photomicrograph showing Experimental example 1.
[FIG. 10A] FIG. 10A is a photomicrograph showing Experimental example 2.
[FIG. 10B] FIG. 10B is a photomicrograph showing Experimental example 2.
[FIG. 10C] FIG. 10C is a photomicrograph showing Experimental example 2.
[FIG. 11A] FIG. 11A is a photomicrograph showing Experimental example 3.
[FIG. 11B] FIG. 11B is a photomicrograph showing Experimental example 3.
[FIG. 11C] FIG. 11C is a photomicrograph showing Experimental example 3.
[FIG. 12A] FIG. 12A is a photomicrograph showing Experimental example 4.
[FIG. 12B] FIG. 12B is a photomicrograph showing Experimental example 4.
[FIG. 13A] FIG. 13A is a photomicrograph showing Experimental example 5.
[FIG. 13B] FIG. 13B is a photomicrograph showing Experimental example 5.
[FIG. 14A] FIG. 14A is a photomicrograph showing Experimental example 5.
[FIG. 14B] FIG. 14B is a photomicrograph showing Experimental example 5.
[FIG. 15A] FIG. 15A is a diagram illustrating a processing method of a variation.
[FIG. 15B] FIG. 15B is a diagram illustrating a processing method of a variation.
[FIG. 15C] FIG. 15C is a diagram illustrating a processing method of a variation.
[FIG. 16A] FIG. 16A is a diagram illustrating a processing method of a variation.
[FIG. 16B] FIG. 16B is a diagram illustrating a processing method of a variation.

### DESCRIPTION OF EMBODIMENTS

Next, embodiments of the present invention will be described with reference to the drawings. In the following description of the drawings, identical or similar parts are denoted by identical or similar reference numerals. However, it should be noted that the drawings are schematic, and the relationship between the thickness and the plane dimension, the ratios of the thickness of layers, or the like, are different from the actual ratios. Therefore, specific thicknesses and dimensions should be determined with reference to the following description. Also, it is needless to say that portions having different dimensional relationships and ratios among the drawings are included.

Further, the following embodiments illustrate a device and a method for embodying the technical concept of the present invention, and the embodiments of the present invention do not specify the following materials, shapes, structures, arrangements, or the like, of components. Various modifications may be made to the embodiments of the present invention within the scope of the claims.

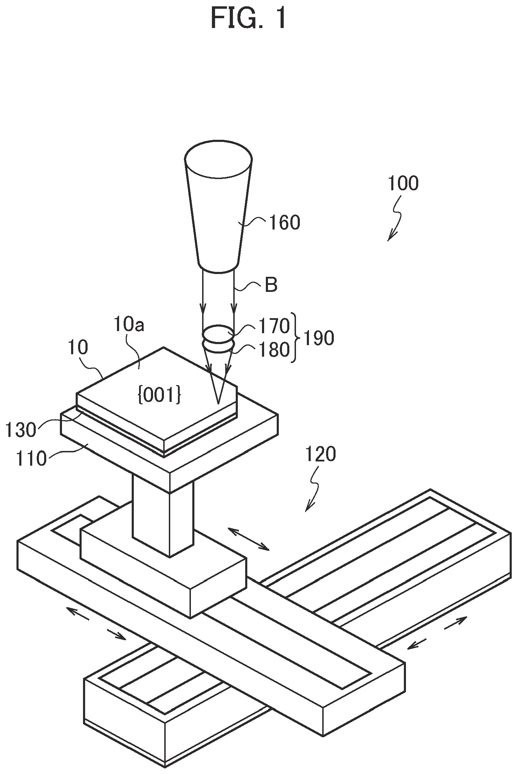

FIG. 1 is a perspective view illustrating a schematic configuration of a processing device 100 used in a diamond processing method of the present embodiment. The processing device 100 includes a stage 110 on which a single crystal diamond substrate 10 is placed, a stage support 120 for supporting the stage 110 to be movable in an XY direction in a horizontal plane, and a fixture 130 for fixing the single crystal diamond substrate 10. A pressure-sensitive adhesive layer, a mechanical chuck, an electrostatic chuck, a vacuum chuck, or the like can be applied to the fixture 130.

The plate-like substrate 10 having a rectangular outer periphery, which is formed by cutting a single crystal diamond ingot to a predetermined length as an object to be processed, is fixed on the stage 110, where a {001} plane having an off-angle of 0 degrees, which is a main surface, serves as a main surface 10a of an upper surface. The shape of the object to be processed is not limited to the description above, and may be, for example, a single crystal diamond ingot, a wafer in a disc shape, or may be a bulk crystal of single crystal diamond, as long as the main surface 10a is the {001} plane.

The processing device 100 includes a laser light source 160 for generating pulsed laser light, and a laser condenser 190 including an objective lens 170 and an aberration adjusting section 180. Laser light B emitted from the laser light source 160 is emitted toward the {001} plane of the main surface 10a of the single crystal diamond substrate 10 via the laser condenser 190.

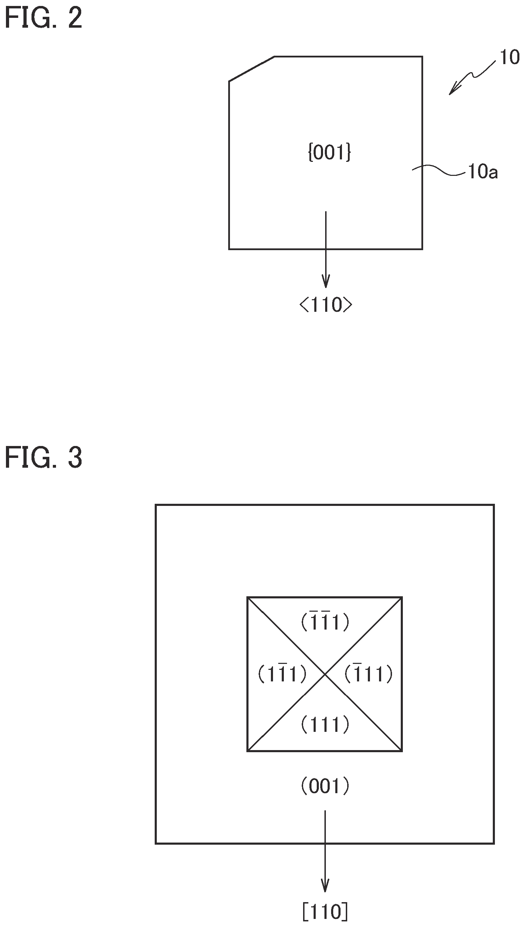

FIG. 2 is a plan view illustrating the substrate 10 to be processed by the processing device 100. The substrate 10 has a rectangular {001} plane serving as the main surface 10a, and the direction indicated by the arrow is defined as a <110> direction. The substrate 10 may have, for example, a (100) plane serving as the main surface 10a, and the direction indicated by the arrow may be defined as a [110] direction. In this case, an orientation flat may be provided by notching the corner in the [0-10] direction of the rectangular substrate 10 to indicate the crystal orientation of the substrate 10. Due to limitation on signs that can be used in this specification, an upper line attached to a number for displaying the Miller index will be replaced by a minus sign "-" before the number, for the sake of convenience.

FIG. 3 is a schematic diagram illustrating arrangement of the {111} plane on the substrate 10. The {111} plane is a cleavage plane of the diamond single crystal substrate 10. FIG. 3 is a plan view of the crystal structure of the substrate 10 with the (001) plane serving as the main surface 10a, viewed from the main surface 10a. The figure also illustrates the orientation of [110]. The {111} plane constitutes the slopes (111), (-111), (-1-11), and (1-11) in a square pyramid protruding from the (100) plane with the (001) plane serving as the bottom surface.

Here, a carbon atom in a diamond single crystal constituting the substrate 10 is covalently bonded to adjacent carbon elements by arms of sp3 hybrid orbitals extending in the direction of the four vertexes of a regular tetrahedron centered on the carbon atoms. The carbon atoms covalently bonded to the adjacent four carbon atoms form a body-centered cubic lattice called a diamond structure. It is known that single crystal diamond is very hard because carbon atoms form covalent bonds with four neighboring carbon atoms in the diamond structure. However, a carbon atom is covalently bonded to one neighboring carbon atom in the <111> direction by a single arm of sp3 hybridization orbital. Therefore, carbon atoms can be separated relatively easily by breaking only this single arm covalent bond in the {111} plane direction orthogonal to the <111> direction, and this {111} plane becomes a cleavage plane.

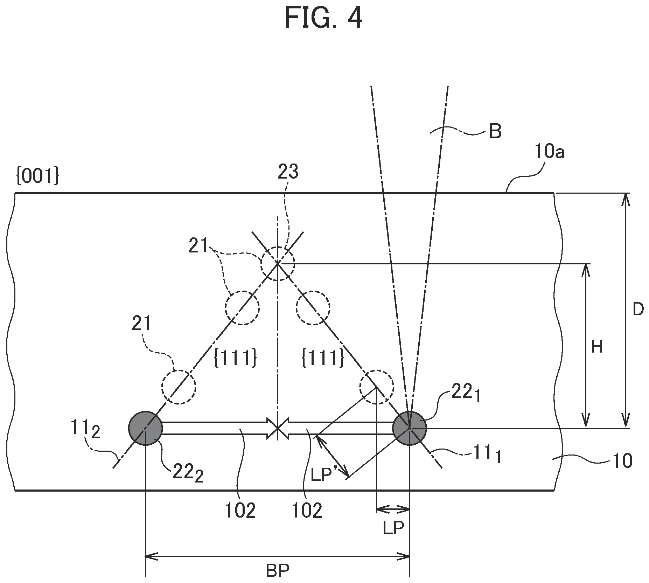

FIG. 4 is a diagram illustrating a principle of the processing method of the present embodiment. In the processing method of this embodiment, a depth D and a starting point pitch BP from the main surface 10a are set, and laser light B is condensed from the laser condenser 190, to form a first starting point 221 and a second starting point 222, which are formed of a processing mark, respectively on a first crystal face 111 and a second crystal face 112 in a {111} plane, which are crossed so as to form a wedge structure with a tip that becomes thinner toward a {001} plane of the main surface 10a inside the substrate 10. Next, the laser light B is emitted in a superimposed manner so that light is condensed to each of the first starting point 221 and the second starting point 222, that is, positions set at the depth D and the starting point pitch BP, to form starting points at these positions. Then, graphitized processing marks are formed on the first crystal face 111 and the second crystal face 112 from the first starting point 221 and the second starting point 222 toward the tip direction of the wedge structure. As a result, the cleavages each extending to the surroundings from the first starting point 221 and the second starting point 222 are formed along the {111} plane including the first crystal face 111 and the second crystal face 112. The depth D is set as a focal depth of the laser light B by the laser condenser 190, and may also be referred to as a focal depth D.

Next, the laser light B is scanned to condense light from the laser condenser 190 so that the depth D is maintained, at a line pitch LP from the first starting point 221 and the second starting point 222 toward the opposing second starting point 222 and first starting point 221, respectively. At this time, the laser light B is set so that it is emitted so as to irradiate, in a superimposed manner, the graphitized processing marks formed from the first starting point 221 and the second starting point 222 on the first crystal face 111 and the second crystal face 112. As a result, while the laser light B is absorbed by the graphitized processing marks and the processing marks 21 are formed in the wedge structure formed by the first crystal face 111 and the second crystal face 112, no processing mark is formed at the focal depth D. Furthermore, at this time, an interval of the line pitch LP is reflected as an interval LP' between the first starting point 221 and the second starting point 222, and the processing mark 21. The direction in which the focus point of the laser light B moves is indicated as a line pitch direction 102 in the figure.

Furthermore, in detail, around the first starting point 221 and the second starting point 222, processing marks that have been graphitized along the {111} plane, which includes the first crystal face 111 and the second crystal face 112, and the cleavages generated around them are formed. When laser light B is focused and emitted to irradiate a position of the depth D, which is advanced by the line pitch LP in the line pitch direction 102 from the first starting point 221 and the second starting point 222, it is absorbed by the graphitized processing marks along the {111} plane extending from the first starting point 221 and the second starting point 222, and is also reflected by the cleavage, to thereby form the respective graphitized processing marks 21. By forming the processing marks 21 onto the first crystal face 111 and the second crystal face 112, the cleavage develops along the first crystal face 111 and the second crystal face 112. Moreover, the laser light B emitted to irradiate the position advanced by the line pitch LP in the line pitch direction 102 is also absorbed by the graphitized processing marks along the first crystal face 111 and the second crystal face 112, and is reflected by the cleavage, to thereby form the respective next processing marks 21 on the first crystal face 111 and the second crystal face 112, and the cleavage along the first crystal face 111 and the second crystal face 112 is also developed. This cleavage is continuously formed along the first crystal face 111 and the second crystal face 112, which allows the diamond substrate 10 to be stripped off at the first crystal face 111 and the second crystal face 112. As mentioned above, the interval of the line pitch LP is reflected as the interval LP' between the processing marks 21, and is optimized by appropriately setting the laser processing conditions as exemplified in the Experiments described later.

The processing marks 21 converge at the tip of the wedge structure where the first crystal face 111 and the second crystal face 112 intersect, and the processing mark 21 formed at the tip of the wedge structure forms an apex 23. Since the processing marks 21 formed along the first crystal face 111 and the second crystal face 112 are also formed in the wedge structure, the processing marks 21 formed along the first crystal face 111 and the second crystal face 112 may also be referred to as processing marks 21 of the wedge structure, hereinafter. The apex 23 is located at a height H from the first starting point 221 and the second starting point 222. On the first crystal face 111 and the second crystal face 112, cleavage is formed accompanying the processing marks 21 that are formed from the first starting point 221 and the second starting point 222 and converge at the apex 23, and a modified layer where cleavage extends to adjacent processing marks is formed. In the modified layer, the cleavages formed along the first crystal face 111 and the second crystal face 112 are connected to each other, extend parallel to the main surface 10a, and terminate at the apex 23. The thickness of the modified layer corresponds approximately to the height H from the first starting point 221 and the second starting point 222 at depth D to the apex 23. The starting point pitch BP between the first starting point 221 and the second starting point 222 can be set based on the height H corresponding to a desired thickness of the modified layer.

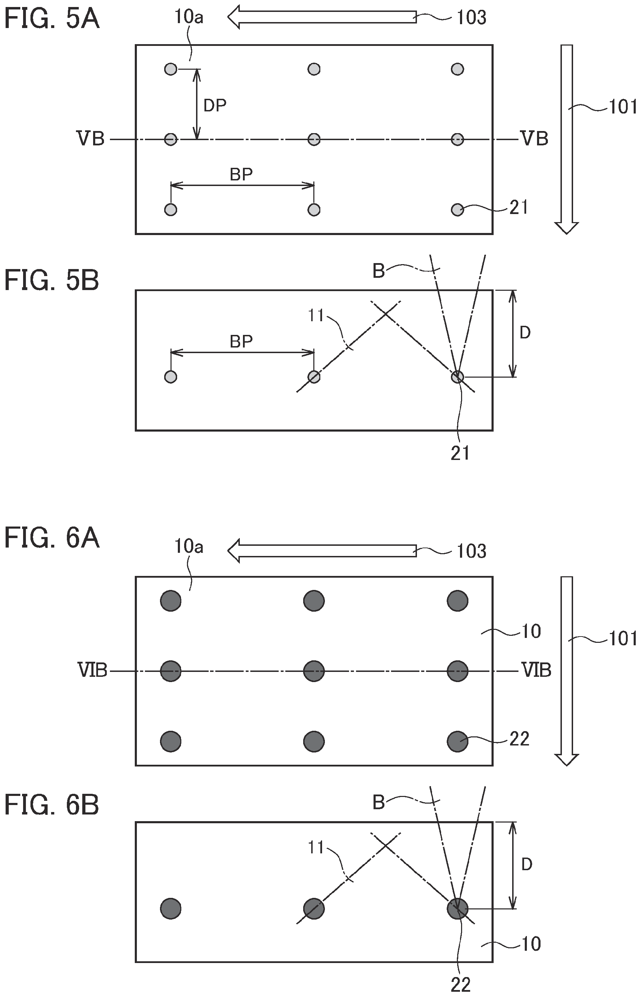

FIG. 5 to FIG. 8 are diagrams illustrating processing methods of the present embodiments. FIG. 4 illustrates the principle of the processing method of the present embodiment in which the cleavages are connected between two points of the first starting point 221 and the second starting point 222 formed on the substrate 10. However, FIG. 5 to FIG. 8 describe a method of forming connected cleavages along the main surface 10a of the substrate 10 by applying the principle illustrated in FIG. 4. Note that, for the sake of convenience, hereinafter, the first crystal face 111 and the second crystal face 112 in FIG. 4 will be referred to as a pair of crystal faces 11, and the starting points formed by emitting the laser light B for the second time to irradiate the first starting point 221 and the second starting point 222 will be referred to as a pair of starting points 22.

FIG. 5 illustrates the processing mark 21 formed by the first irradiation with laser light B at the position of the starting point 22 to form the starting point 22 on the substrate 10. FIG. 5A is a plan view of the substrate 10, and FIG. 5B is a cross-sectional view of the substrate 10 taken along the cutting line VB-VB in FIG. 5A.

Inside the substrate 10, at a depth D on a plane composed of a pair of crystal faces 11 in a {111} plane that intersect to form a wedge structure with a tip that becomes thinner toward a {001} plane of the main surface 10a, processing marks 21 are formed in the starting point pitch direction 103 at the starting point pitch BP. The starting point pitch direction is one direction of the line pitch direction 102 illustrated in FIG. 4. A pair of processing marks 21 adjacent to the starting point pitch direction 103 is present on a pair of crystal faces that forms a wedge structure and is only separated by the starting point pitch BP. Such processing marks 21 are formed in the dot pitch direction 101 at a dot pitch DP. The dot pitch direction 101 is one direction that is orthogonal to the starting point pitch direction 103 in a plane parallel to the main surface 10a. A row of processing marks 21 are formed by scanning the laser light B in the dot pitch direction 101 at a dot pitch DP. After the formation of this row of processing marks 21 is completed, the laser light B is moved in the starting point pitch direction 103 and scanning is repeated on an adjacent row of processing marks in the same manner to form processing marks 21. The laser light B is condensed and irradiates the substrate 10 to the depth D.

FIG. 6 illustrates the starting point 22 formed by the second irradiation with the laser light B on the processing mark 21 formed by the first irradiation with the laser light B on the substrate 10. FIG. 6A is a plan view of the substrate 10, and FIG. 6B is a cross-sectional view of the substrate 10 taken along the cutting line VIB-VIB in FIG. 6A. The laser light B is scanned in the dot pitch direction 101, and the second irradiation is performed on the row of processing marks 21, to thereby form the starting point 22. After that, the light beam B is moved in the starting point pitch direction 103, and the second irradiation is performed on an adjacent row of processing marks 21 in the same manner, to form the starting point 22. The laser light B is condensed and irradiates the substrate 10 to the depth D.

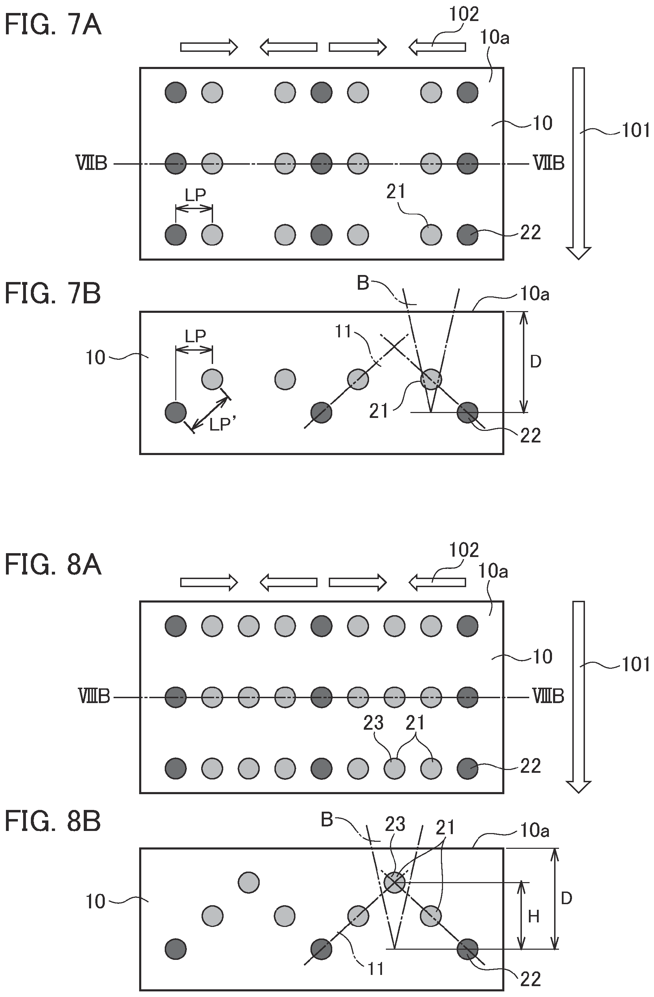

FIG. 7 illustrates the processing marks 21 formed toward the starting points 22 that face each other along the starting point pitch direction 103 from the starting point 22 formed by condensing the laser light again on the first starting point 221 and the second starting point 222. FIG. 7A is a plan view of the substrate 10, and FIG. 7B is a cross-sectional view of the substrate 10 taken along the cutting line VIIB-VIIB in FIG. 7A. Each of the processing marks 21 is formed in the line pitch direction 102 from the starting point 22 toward the opposing starting point 22, at a line pitch LP. The laser light B is scanned in the dot pitch direction 101, to thereby form a row of processing marks 21. After that, the light beam B is moved in the starting point pitch direction 103, and irradiation is performed on the row of processing marks 21 in the same manner, to form the processing marks 21. The laser light B is condensed and irradiates the substrate 10 to the depth D similarly to the starting point 22. As described above, the laser light B is condensed and irradiates the substrate 10 to the depth D, but the processing mark 21 is formed on a set of crystal faces 11 forming a wedge shape, at the interval LP'.

FIG. 8 illustrates the processing marks 21, which are formed toward the starting points 22 that face each other along the starting point pitch direction 103 from the starting point 22 formed by condensing the laser light again on the first starting point 221 and the second starting point 222, and which converge at the apex 23. FIG. 8A is a plan view of the substrate 10, and FIG. 8B is a cross-sectional view of the substrate 10 taken along the cutting line VIIIB-VIIIB in FIG. 8A. Each of the processing marks 21 formed in the line pitch direction 102 from the starting point 22 toward the opposing starting point 22 at the line pitch LP forms the processing mark 21 that becomes the apex 23 at the tip of the wedge structure formed by the set of crystal faces 11. The laser light B is scanned in the dot pitch direction 101, to thereby form a row of processing marks 21 of the apex 23. After that, the light beam B is moved in the starting point pitch direction 103, and the formation of an adjacent row of processing marks 21 of the apex is repeated in the same manner, to form the processing mark 21 of the apex 23. The laser light B is condensed and irradiates the substrate 10 to the depth D similarly to the starting point 22. As described above, the laser light B is condensed and irradiates the substrate to the depth D, but the processing mark 21 of the apex 23 is formed at the tip of the wedge shape formed by the set of crystal faces 11. The processing mark 21 of the apex 23 is at the height H from the starting point 22 at the depth D.

Note that, the processing mark 21 is connected at this apex 23, but in detail, it is in a state where the modified layer also including cleavage is connected. It is preferable that the development of the modified layer is completed at this apex 21, and that cleavage and the modified layer do not extend significantly in the direction of the main surface from apex 21.

In this way, the processing mark 21 is formed along the main surface 10a of the substrate 10 through the series of steps illustrated in FIG. 5 to FIG. 8. The cleavages extending between the processing marks 21 adjacent in the starting point pitch direction 103 or the line pitch direction 102 are connected to each other, and the cleavages extending between the processing marks 21 adjacent in the dot pitch direction 101 are also connected to each other, thereby forming a modified layer that extends in a parallel manner along the main surface 10a. The thickness of the modified layer corresponds approximately to the height H from the starting point 22 to the apex 23.

### (Experimental example 1)

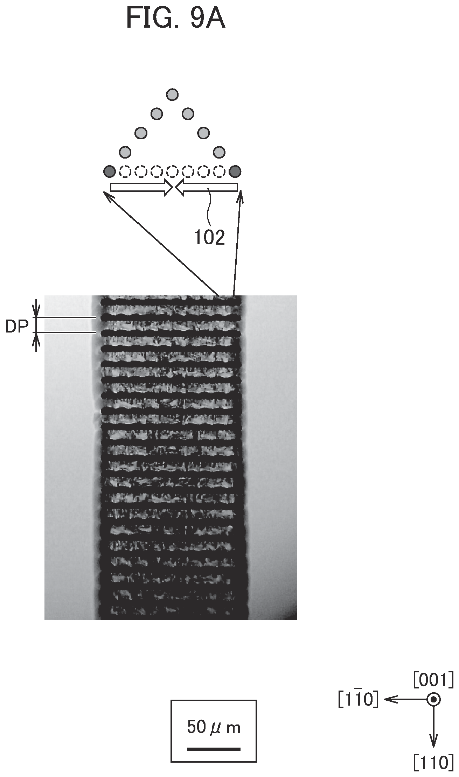

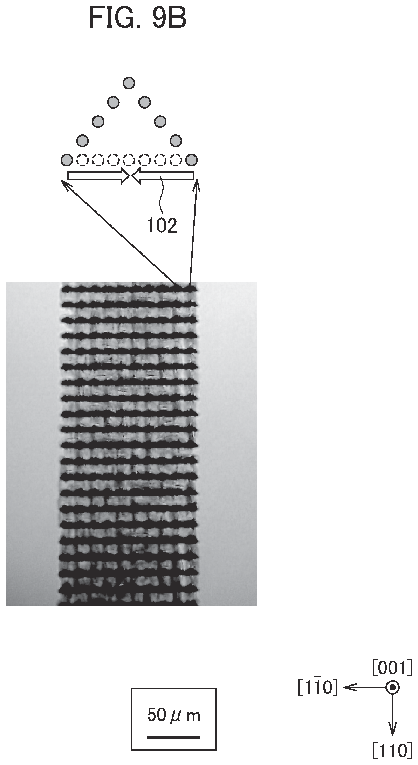

FIG. 9 is a photomicrograph showing results of Example 1. FIG. 9A shows a photomicrograph of the substrate 10 processed according to Experimental example 1, and FIG. 9B shows a photomicrograph of the substrate 10 of Comparative Example that does not form a starting point. In Experimental example 1, the substrate 10 was processed under the processing conditions shown in the following Table 1 according to the processing method of the present embodiment. The starting point pitch BP is set to 80 µm, and the height H is set to 9.42 µm. In the substrate 10 of Experimental example 1 shown in FIG. 9A, processing marks 21 were formed in the line pitch direction 102 at the dot pitch DP, and it was observed that a graphitization state around the processing marks 21 and cleavage around them were also generated. It was also observed that the cleavages are connected in the direction of the dot pitch DP. FIG. 9A shows a schematic view of the processing marks 21 formed in the line pitch direction 102 along the pair of crystal faces 11 forming a wedge structure from the starting point 22, as shown in FIG. 4, and the correspondence between the photomicrograph and the wedge structure of the processing marks 21 is clarified.

**[Table 1]**

| Machining Conditions | | |
|---|---|---|
| Wavelength | nm | 1030 |
| Oscillatory Frequency | kHz | 0.3 |
| Pulse Width | ps | 10 |
| Pulse Energy | µJ | 1.5 |
| Focal Depth D | µm | 250 |
| Height H | µm | 9.42 |
| Starting Point Pitch BP | µm | 80 |
| Dot Pitch DP | µm | 15 |
| Line Pitch LP | µm | 1.1 |
| Interval between Processing Marks LP' | µm | 1.917(≈2) |
| Number of Processed Wedge Structures | | 10 |

In Comparative Example of FIG. 9B, the substrate 10 was processed under the same processing conditions as those of Experimental example 1 except that the starting point 22 was not formed and the starting point 22 was changed to the processing mark 21. As mentioned above, the starting point 22 is formed by irradiating the processing mark 21 with the second laser light B after the processing mark 21 is formed by irradiation with the first laser light B. Therefore, by completing irradiation with the laser light B once to the position irradiated by the laser light B twice to form the starting point 22 in Experimental example 1, the processing mark 21 is formed instead of the starting point 22. Referring to FIG. 9B, it was observed that processing marks are formed in the line pitch direction 102 in the same manner as in FIG. 9A of Experimental example 1, but much cleavage does not extend around the processing marks 21 compared to Experimental example 1.

### (Experimental example 2)

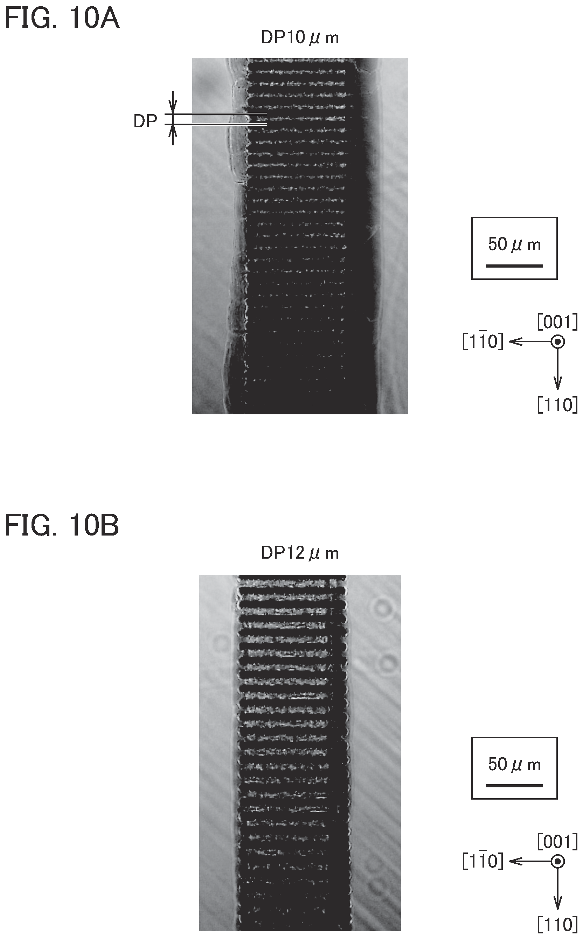

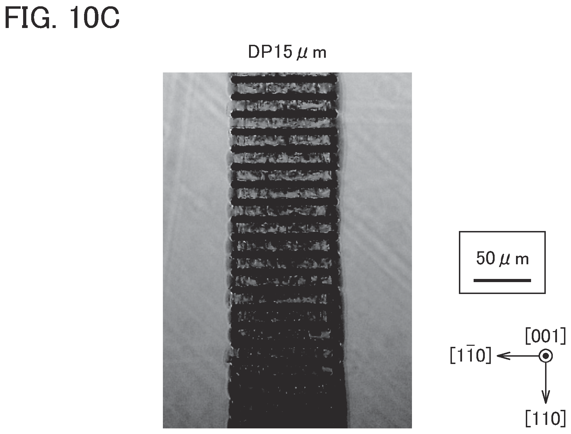

FIG. 10 is a photomicrograph showing results of Example 2. FIG. 10A shows a photomicrograph of the substrate 10 processed with a dot pitch DP of 10 µm, FIG. 10B shows a photomicrograph of the substrate 10 processed with a dot pitch DP of 12 µm, and FIG. 10C shows a photomicrograph of the substrate 10 processed with a dot pitch DP of 15 µm. As shown in the following Table 2, the processing conditions of Experimental example 2 differ from those of Experimental example 1 in that the values of the height H and the starting point pitch BP are changed and the number of dot pitches DP is increased, but other processing conditions are the same as those of Experimental example 1. In all cases of FIG. 10A with a dot pitch DP of 10 µm, FIG. 10B with a dot pitch DP of 12 µm, and FIG. 10C with a dot pitch DP of 15 µm, it was observed that processing marks 21 are formed in the line pitch direction 102, and the processing marks 21 are graphitized and cleavage extends around them, similarly to FIG. 9A of Experimental example 1. It was also observed that the cleavages are connected in the direction of the dot pitch DP.

**[Table 2]**

| Machining Conditions | | |
|---|---|---|
| Wavelength | nm | 1030 |
| Oscillatory Frequency | kHz | 0.3 |
| Pulse Width | ps | 10 |
| Pulse Energy | µJ | 1.5 |
| Focal Depth D | µm | 250 |
| Height H | µm | 6.28 |
| Starting Point Pitch BP | µm | 8.8 |
| Dot Pitch DP | µm | 10, 12, 15 |
| Line Pitch LP | µm | 1.1 |
| Interval between Processing Marks LP' | µm | 1.917(≈2) |
| Number of Processed Wedge Structures | | 10 |

### (Experimental example 3)

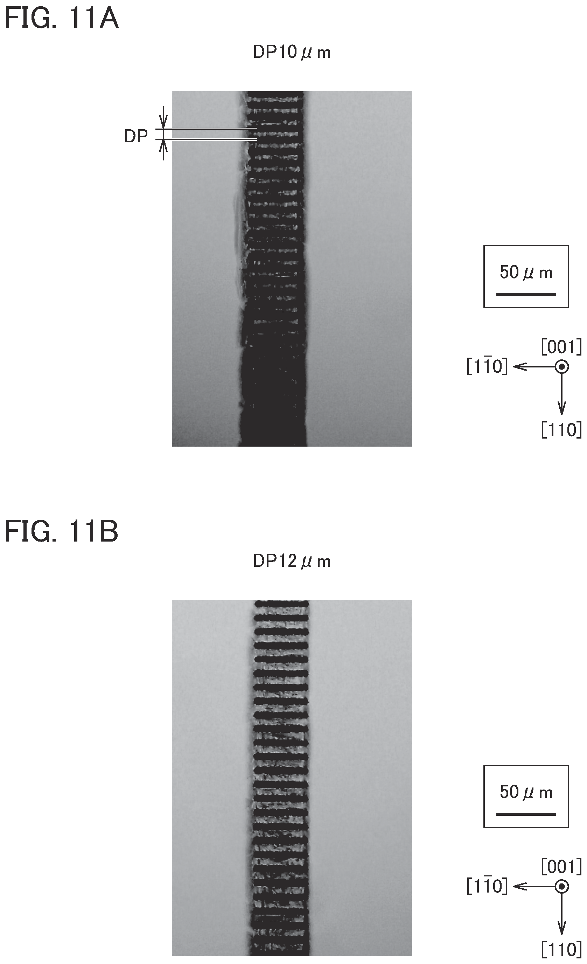

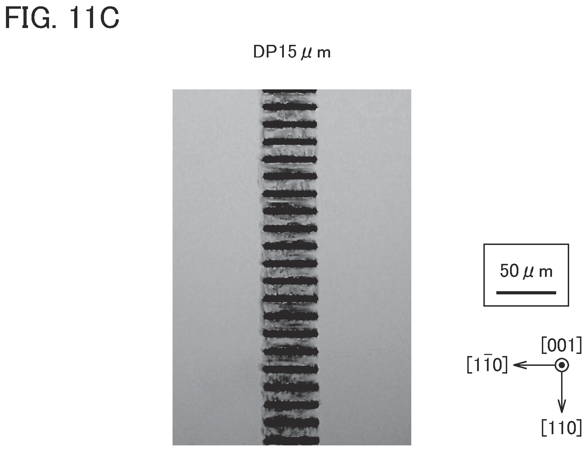

FIG. 11 is a photomicrograph showing results of Example 3. FIG. 11A shows a photomicrograph of the substrate 10 processed with a dot pitch DP of 10 µm, FIG. 11B shows a photomicrograph of the substrate 10 processed with a dot pitch DP of 12 µm, and FIG. 11C shows a photomicrograph of the substrate 10 processed with a dot pitch DP of 15 µm. As shown in the following Table 3, the processing conditions of Experimental example 3 differ from those of Experimental example 1 in that the values of the height H and the starting point pitch BP and the interval of dot pitches DP are changed, but other processing conditions are the same as those of Experimental example 1. In all cases of FIG. 11A with a dot pitch DP of 10 µm, FIG. 11B with a dot pitch DP of 12 µm, and FIG. 11C with a dot pitch DP of 15 µm, it was observed that processing marks 21 are formed in the line pitch direction 102, and the processing marks 21 are graphitized and cleavage extends around them, similarly to FIG. 9A of Experimental example 1. It was also observed that the cleavages are connected in the direction of the dot pitch DP.

In the present Experimental example, since the height H is set to 3.14 µm, there is an advantage that the thickness of the modified layer formed inside the diamond substrate 10 becomes smaller.

**[Table 3]**

| Machining Conditions | | |
|---|---|---|
| Wavelength | nm | 1030 |
| Oscillatory Frequency | kHz | 0.3 |
| Pulse Width | ps | 10 |
| Pulse Energy | µJ | 1.5 |
| Focal Depth D | µm | 250 |
| Height H | µm | 3.14 |
| Starting Point Pitch BP | µm | 4.4 |
| Dot Pitch DP | µm | 10, 12, 15 |
| Line Pitch LP | µm | 1.1 |
| Interval between Processing Marks LP' | µm | 1.917(≈2) |
| Number of Processed Wedge Structures | | 10 |

### (Experimental example 4)

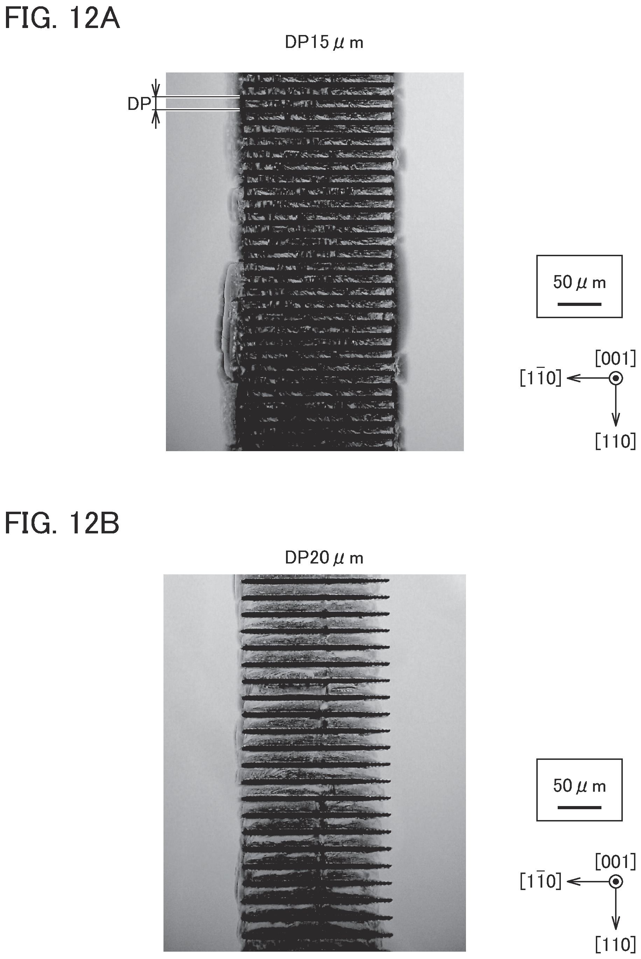

FIG. 12 is a photomicrograph showing results of Example 4. FIG. 12A shows a photomicrograph of the substrate 10 processed with a dot pitch DP of 15 µm, and FIG. 12B shows a photomicrograph of the substrate 10 processed with a dot pitch DP of 20 µm. In Experimental example 4, the number of processing lines is increased compared to Experimental examples 1 to 3. As shown in the following Table 4, the processing conditions of Experimental example 4 differ from those of Experimental example 1 in that the values of the height H, the starting point pitch LP, and the number of processed wedge structures are changed and the number of dot pitches DP is increased, but other processing conditions are the same as those of Experimental example 1. In FIG. 12A with a dot pitch DP of 15 µm, it was observed that processing marks 21 are formed in the line pitch direction 102, and cleavage extends around the processing marks 21. It was also observed that the cleavages are connected in the direction of the dot pitch DP. On the other hand, in FIG. 12B with a dot pitch DP of 20 µm, it was observed that processing marks 21 are formed in the line pitch direction 102, and the processing marks 21 are graphitized and cleavage extends around them, but it was observed that cleavages are not sufficiently connected in the direction of dot pitch DP. Since it was observed that cleavages are not sufficiently connected at a dot pitch DP of 20 µm, it is considered that the upper limit value of the dot pitch DP is 15 µm regarding the dot pitch DP direction.

**[Table 4]**

| Machining Conditions | | |
|---|---|---|
| Wavelength | nm | 1030 |
| Oscillatory Frequency | kHz | 0.3 |
| Pulse Width | ps | 10 |
| Pulse Energy | µJ | 1.5 |
| Focal Depth D | µm | 250 |
| Height H | µm | 3.14 |
| Starting Point Pitch BP | µm | 4.4 |
| Dot Pitch DP | µm | 15, 20 |
| Line Pitch LP | µm | 1.1 |
| Interval between Processing Marks LP' | µm | 1.917(≈2) |
| Number of Processed Wedge Structures | | 40 |

### (Experimental example 5)

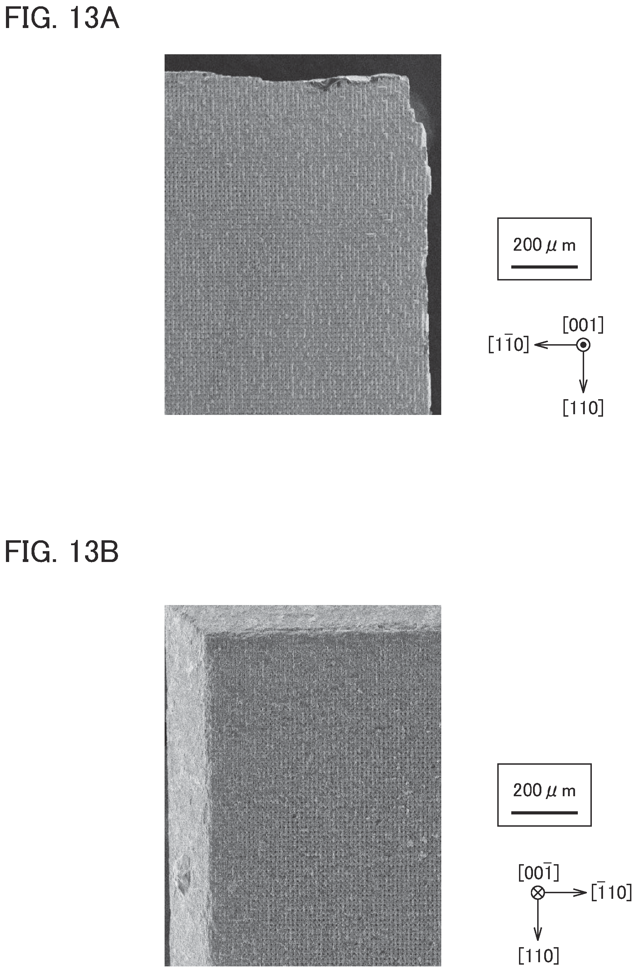

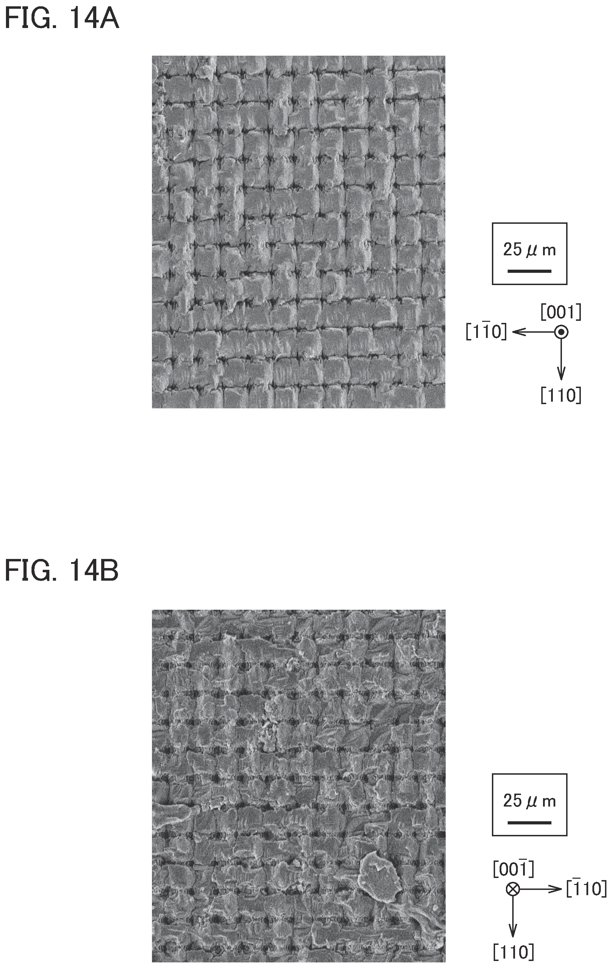

FIG. 13 and FIG. 14 are photomicrographs showing results of Example 5. FIG. 13A is a photomicrograph of the bottom surface of the stripped substrate 10, and FIG. 13B is a photomicrograph of the upper surface. FIG. 14A and FIG. 14B are enlarged photomicrographs of the photomicrographs of FIG. 13A and FIG. 13B, respectively. In Experimental example 5, after cleavage connected along the main surface 10a of the substrate 10 by the processing method of the present embodiment was formed, the substrate 10 was divided into the upper and bottom pieces with the connected cleavage. As shown in the following Table 5, the processing conditions of Experimental example 4 differ from those of Experimental example 1 in that the values of the height H and the starting point pitch LP are changed and the number of dot pitches DP is increased, but other processing conditions are the same as those of Experimental example 1. In Experimental example 5, since numerous processing marks 21 of the wedge structures were formed so as to cover the main surface 10a, the number of processed wedge structures is not specified in Table 5.

Referring to FIG. 13A and FIG. 13B, it is observed that the connected cleavage was formed over the substantially entire surface of the main surface 10a of the substrate 10, and the substrate 10 was divided along the connected cleavage. Referring to FIG. 13A, FIG. 13B, FIG. 14A, and FIG. 14B, it is observed that square pyramids formed by the {111} plane, as shown in FIG. 3, were regularly formed on both the stripped surfaces of the lower surface and the upper surface, and that stripping occurred along the connected cleavage formed along the {111} plane. In the connected cleavage, square pyramids by the {111} plane are arranged to form the {001} plane parallel to the main surface 10a.

As illustrated in the present Experimental example, it is necessary for the processing marks formed on the {111} planes constituting the wedge structure to be graphitized and connected to develop cleavage in order to strip the substrate 10, and the interval LP' between these processing marks is preferably 3 µm or less. When the interval LP' between the processing marks is more than 3 µm, the processing marks become dot-like and are not connected. To keep the interval between these processing marks at 3 µm or less, the laser light scanning interval LP must be 1.7 µm or less.

In the present Experimental example, the line pitch LP is 1.1 µm, and the interval LP' between the processing marks is 1.917 ≈ 2 µm.

**[Table 5]**

| Machining Conditions | | |
|---|---|---|
| Wavelength | nm | 1030 |
| Oscillatory Frequency | kHz | 0.3 |
| Pulse Width | ps | 10 |
| Pulse Energy | µJ | 1.5 |
| Focal Depth D1 | µm | 250 |
| Height D2 | µm | 3.14 |
| Starting Point Pitch BP1 | µm | 4.4 |
| Dot Pitch DP | µm | 15 |
| Line Pitch LP | µm | 1.1 |
| Interval between Processing Marks LP' | µm | 1.917(≈2) |

As described above, according to the present embodiment, it was possible to manufacture a diamond substrate having a {001} plane as a main surface by stripping off the single crystal diamond substrate 10 having a {001} plane as a main surface. In the present embodiment, since the cleavages generated from the processing marks so as to extend along the {111} plane are connected, the width of the modified layer including the processing marks and cleavage around the processing marks is relatively small. Since the portion of the modified layer that serves as an allowance when the substrate 10 is divided is relatively small, the single crystal diamond substrate 10 can be effectively utilized.

### (Variations)

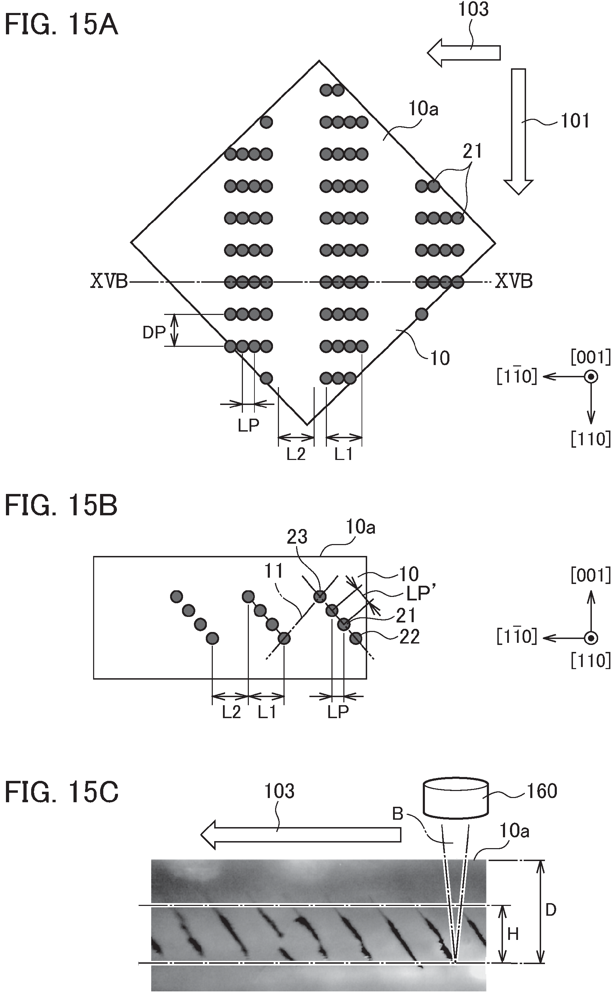

FIG. 15 is a diagram illustrating a first step of a processing method of a variation. FIG. 15A is a plan view of the substrate 10, FIG. 15B is a cross-sectional view of the substrate 10 taken along the cutting line XVB-XVB of FIG. 15A, and FIG. 15C is a photomicrograph of the cross-section of FIG. 15B. In the processing method of the present embodiment shown in FIG. 5 to FIG. 8, processing marks 21 are formed sequentially from a pair of opposing starting points 22 towards the apex 23, whereas the variation is different in that processing is performed by a first step of forming processing marks 21 from one of the opposing starting points 22 towards the apex 23 in the starting point pitch direction 103 and then a second step of forming processing marks 21 from the other starting point 22 towards the apex 23 in the opposite direction of the starting point pitch direction 103. Other configurations of the variation, such as the formation of the starting point 22, are the same as those of the processing method of the embodiment. FIG. 15 shows the processing marks 21 formed in the first step of these steps.

As illustrated in FIG. 15A and FIG. 15B, processing marks 21 are formed at the line pitch LP from the starting point 22 toward the apex 23 in the starting point pitch direction 103 along one of the pair of crystal faces 11 that forms the wedge structure inside the substrate 10. The laser light B is scanned in the dot pitch direction 101 to form a row of processing marks 21. After this row of processing marks 21 is formed, the second irradiation with the laser light B is performed in order to form the starting point. Next, the laser light B is moved in the starting point pitch direction 103 and scanning is repeated on an adjacent row of processing marks in the same manner, to form processing marks. The laser light B is condensed and irradiates the substrate 10 to the depth D. In the line pitch direction 103, both the processing width L1 for forming the processing marks 21 in the first step and the movement width L2 for moving without forming processing marks 21 were similarly set to 40 µm.

The photomicrograph in FIG. 15C shows the processing marks 21 formed from the starting point 22 toward the apex 23 in the starting point pitch direction 103 along one of the pair of crystal faces 11. The starting point 22 is formed at the depth D of the substrate 10, and the apex 23 is formed at the height H from the depth D. It is observed that processing marks 21 are formed from the starting point 22 toward the apex 23 at the height H along one of the pair of crystal faces 11.

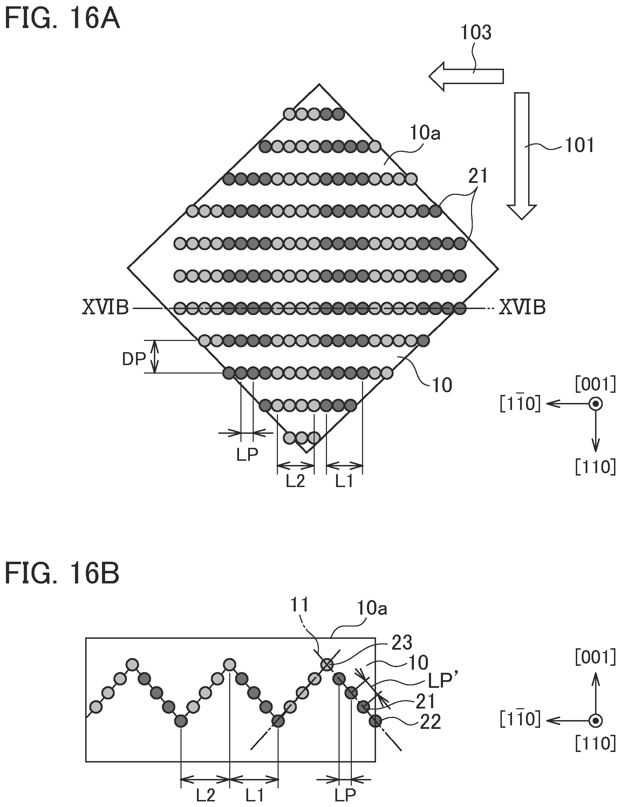

FIG. 16 is a diagram illustrating a second step of a processing method of a variation. FIG. 16A is a plan view of the substrate 10, and FIG. 16B is a cross-sectional view of the substrate 10 taken along the cutting line XVIB-XVIB in FIG. 16A. FIG. 15 shows the processing marks 21 formed in the first step of these steps.

As illustrated in FIG. 16A and FIG. 16B, processing marks 21 are formed at the line pitch LP from the starting point 22 toward the apex 23 in the direction opposite to the starting point pitch direction 103 along the other of the pair of crystal faces 11 that forms the wedge structure inside the substrate 10. After the laser light B is scanned in the dot pitch direction 101 to form a row of processing marks 21, the second irradiation with the laser light B is performed in order to form the starting point. Next, the laser light B is moved in the direction opposite to the starting point pitch direction 103 and scanning is repeated on an adjacent row of processing marks in the same manner, to form processing marks. The laser light B is condensed and irradiates the substrate 10 to the depth D. In the line pitch direction 102, both the processing width L2 for forming the processing marks 21 in the second step and the movement width L1 for moving without forming processing marks 21 were similarly set to 40 µm.

Thus, after the step of forming the starting point 22, processing marks 21 are formed along the main surface 10a of the substrate 10 by performing the first step shown in FIG. 15 and the second step shown in FIG. 16. The cleavages extending between the processing marks 21 adjacent in the starting point pitch direction 103 are connected to each other, and the cleavages extending between the processing marks 21 adjacent in the dot pitch direction 101 are also connected to each other, thereby forming a modified layer that extends in a parallel manner along the main surface 10a. The thickness of the modified layer corresponds approximately to the height H from the starting point 22 to the apex 23.

According to the variation, in the first step, processing marks 21 are formed along one of the crystal faces 11 that forms a wedge structure, and, in the second step, processing marks are formed along the other of the crystal faces 11 that forms the wedge structure. Since the processing marks 21 are each continuously formed on one and the other of the crystal faces 11, the movement distance of the laser condenser 190 that condenses and emits the laser light B to form the processing marks 21 is shortened. Therefore, according to the variation, the time required to form the wedge structure of the processing mark 21 is shortened, which makes it possible to process the substrate 10 at a high speed.

The embodiments and Experimental examples have been described above. However, these embodiments and Experimental examples are merely examples for embodying the technical concept of the present invention, and the scope of the invention is not intended to be limited thereto. The embodiments may be possible in various other forms, and various omissions, substitutions, and changes may be made without departing from the gist of the invention.

This application claims priority under Japanese Patent Application No. 2023-140527, filed August 30, 2023, and the entire contents of which are hereby incorporated by reference.

### REFERENCE SIGNS LIST

- 10: Substrate
- 10a: Main surface
- 11: Crystal face
- 21: Processing mark
- 22: Starting point
- 23: Apex
- 101: Dot pitch direction
- 102: Line pitch direction
- 103: Starting point pitch direction
- 190: Laser condenser

## Claims

1. A method of processing a substrate, comprising:
a step of arranging a laser condenser configured to condense laser light, to face a main surface of a {001} plane of a single crystal diamond substrate;
a step of forming a first starting point and a second starting point formed of processing marks by condensing the laser light using the laser condenser and irradiating, with the laser light, positions each set on a first crystal face and a second crystal face that form a wedge structure with a tip that becomes thinner toward the main surface inside the substrate, among crystal faces constituting a {111} plane;
a step of forming starting points on the processing marks formed, by condensing the laser light using the laser condenser and irradiating the first starting point and the second starting point in a superimposed manner; and
a step of forming processing marks by condensing the laser light using the laser condenser and irradiating positions between the first starting point and the second starting point with the laser light so that cleavages each extend along the first crystal face and the second crystal face from the starting point and are connected at the tip of the wedge structure.

2. The method of processing a substrate according to claim 1, wherein in the step of forming processing marks, a modified layer including processing marks obtained by pyrolyzing diamond into graphite and cleavage formed around the processing marks along the {111} plane is formed.

3. The method of processing a substrate according to claim 1, wherein the first starting point and the second starting point are set at the same depth from the main surface of the substrate.

4. The method of processing a substrate according to claim 3, wherein in the step of forming processing marks by irradiating positions between the first starting point and the second starting point with the laser light, the laser light is condensed to the same depth as the depth of the first starting point and the second starting point to form processing marks.

5. The method of processing a substrate according to claim 4, wherein in the step of forming processing marks by irradiating positions between the first starting point and the second starting point with the laser light, processing marks are each formed so as to converge at the tip of the wedge structure along the first crystal face and the second crystal face from the first starting point and the second starting point toward the second starting point and the first starting point that are faced.

6. The method of processing a substrate according to claim 4, wherein the step of forming processing marks by irradiating positions between the first starting point and the second starting point with the laser light includes:
a step of forming processing marks from one of the first starting point and the second starting point toward the other of the first starting point and the second starting point along the first crystal face or the second crystal face to the tip of the wedge structure; and
a step of forming processing marks from the other of the first starting point and the second starting point toward one of the first starting point and the second starting point along the first crystal face or the second crystal face to the tip of the wedge structure.

7. The method of processing a substrate according to claim 1, wherein in the step of forming processing marks by irradiating positions between the first starting point and the second starting point with the laser light, a modified layer including processing marks obtained by pyrolyzing diamond into graphite and cleavage around the processing marks along the {111} plane is formed.

8. The method of processing a substrate according to claim 1, wherein the step of forming processing marks by irradiating positions between the first starting point and the second starting point with the laser light includes:
a step of forming processing marks to form cleavage from the first starting point along the first crystal face to the tip of the wedge structure, and
a step of forming processing marks to form cleavage from the second starting point along the second crystal face to the tip of the wedge structure.
